# EUROPÄISCHE PATENTANMELDUNG

(11) **EP 2 511 714 A2**
(43) Veröffentlichungstag der Anmeldung: **17.10.2012**
(21) Anmeldenummer: 12150557.2
(22) Anmeldetag: 10.01.2012
(51) Int. Cl.: G01R 19/00, G01R 19/25

(54) **Sensorbaugruppe, Sensorsteuerung und Strommessschaltung**

(30) Priorität: 15.04.2011 US 201161475783 P
(71) Anmelder: Magna E-Car Systems GmbH & Co OG, 8041 Graz (AT)
(72) Erfinder: Mandic, Renato, 8010 Graz (AT); Plank, Roland, 8071 Gössendorf (AT); Poscharnig, Guido, 8046 Stattegg (AT)
(74) Vertreter: Rausch, Gabriele

(57) **Zusammenfassung**

Eine Sensorbaugruppe (14) zur Messung einer Stärke eines Stroms (Iₘ) umfasst eine erste Sensorvorrichtung (51) zur nicht kontaktfreien Erfassung der Stärke des Stroms (Iₘ) und eine zweite Sensorvorrichtung (53) zur Erfassung der Stärke des Stroms (Iₘ), wobei beide Sensorvorrichtungen (51, 53) einen gemeinsamen Messbereich aufweisen. Unter einem ersten Aspekt umfasst die Sensorbaugruppe (14) einen ersten Analog-Digital-Wandler (41) zur Wandlung von analogen Messwerten (U₁) in digitalisierte Messwerte (U_{1D}), wobei die beiden Sensorvorrichtungen (51, 53) und der erste Analog-Digital-Wandler (41) auf einem gemeinsamen Schaltungsträger (47) angeordnet sind. Unter einem zweiten Aspekt ist eine Messgenauigkeit der zweiten Sensorvorrichtung (53) im gemeinsamen Messbereich schlechter als 0,5 %, insbesondere schlechter als 1 % oder 2%, insbesondere schlechter als 5%, ganz besonders bevorzugt schlechter als 10 %.

## Beschreibung

Die Erfindung betrifft eine erste Sensorbaugruppe zur Messung einer Stärke eines durch einen Leiter fließenden elektrischen Stroms, wobei die Sensorbaugruppe eine erste Sensorvorrichtung zur nicht kontaktfreien Erfassung der Stärke des elektrischen Stroms und eine zweite Sensorvorrichtung zur Erfassung der Stärke des elektrischen Stroms umfasst, wobei beide Sensorvorrichtungen einen gemeinsamen Messbereich aufweisen, wobei die Sensorbaugruppe einen ersten Analog-Digital-Wandler zur Wandlung von analogen Messwerten in digitalisierte Messwerte umfasst.

Unter einem zweiten Aspekt betrifft die Erfindung eine zweite Sensorbaugruppe zur Messung einer Stärke eines durch einen Leiter fließenden elektrischen Stroms, wobei die Sensorbaugruppe eine erste Sensorvorrichtung zur nicht kontaktfreien Erfassung der Stärke des elektrischen Stroms und eine zweite Sensorvorrichtung zur Erfassung der Stärke des elektrischen Stroms umfasst, wobei beide Sensorvorrichtungen einen gemeinsamen Messbereich aufweisen.

Des Weiteren betrifft die Erfindung eine erste Sensorsteuerung zur Steuerung einer Sensorbaugruppe.

Außerdem betrifft die Erfindung eine zweite Sensorsteuerung zur Steuerung einer Sensorbaugruppe.

Darüberhinaus betrifft die Erfindung eine Strommessschaltung zur Messung der Stärke eines elektrischen Stroms.

Die DE 100 60 490 A1 beschreibt eine Einrichtung zur Überwachung eines Bordnetzes eines Fahrzeugs mit einem Sensor zur Messung von in einer Anschlussleitung fließendem elektrischem Strom. Um für die Strommessung insgesamt einen größeren Messbereich abzudecken, als mit einem einzelnen Sensor erfasst werden kann, sind zwei Sensoren mit unterschiedlichen Messbereichen vorgesehen. Für eine Messung von Strömen zwischen 10 mA und 10 A ist ein Hallsensor vorgesehen. Zur Messung von Strömen zwischen 1 A und 10 kA ist ein Widerstand (Shunt) als Sensor vorgesehen, der in der Anschlussleitung angeordnet ist. Der Spannungsabfall, den der zu messende Strom an dem Shunt hervorruft, dient als Hilfsmessgröße zur Bestimmung des Werts des zu messenden Stroms.

Es ist eine Aufgabe der Erfindung, eine Sensorbaugruppe bereitzustellen, die - im Vergleich zu bekannten Sensorbaugruppen - den Herstellungsaufwand für ein Stromversorgungssystem, insbesondere für ein Bordnetz eines Kraftfahrzeugs, verringert. Außerdem ist es eine Aufgabe der Erfindung, eine Sensorsteuerung und eine Strommessschaltung mit diesem Vorteil bereitzustellen.

Diese Aufgabe wird mit den unabhängigen Patentansprüchen gelöst. Vorteilhafte Weiterbildungen des Erfindungsgedankens sind Gegenstand der Unteransprüche.

Erfindungsgemäß ist die erste Sensorbaugruppe dadurch weitergebildet, dass die beiden Sensorvorrichtungen und der erste Analog-Digital-Wandler auf einem gemeinsamen Schaltungsträger angeordnet sind. Dadurch, dass eine relative Lage der beiden Sensorvorrichtungen schon bei der Herstellung der Sensorbaugruppe auf demselben Schaltungsträger exakt positionier- und fixierbar sind, können aufwändige Justierarbeiten während des Einbaus der Sensorbaugruppe ins Zielgerät, beispielsweise beim Einbau in ein Fahrzeug, vermieden werden.

Unter einem zweiten Aspekt ist die zweite Sensorbaugruppe dadurch weitergebildet, dass eine Messgenauigkeit der zweiten Sensorvorrichtung im gemeinsamen Messbereich schlechter als 0,5 %, insbesondere schlechter als 1 % oder 2%, insbesondere schlechter als 5%, ganz besonders bevorzugt schlechter als 10 %, ist. Hierdurch kann für die zweite Sensorvorrichtung ein Sensor und/oder ein Analog-Digital-Wandler verwendet werden, der kostengünstiger ist als der Sensor bzw. Analog-Digital-Wandler für die erste Sensorvorrichtung. Die Genauigkeit der gesamten Messkette für die Strommessung ausgehend vom Spannungsabfall am Shunt beträgt beispielsweise 0,5% vom Messwert +- 20 mA Offset. Die Genauigkeit der gesamten Messkette für die Strommessung mittels eines Hallsensors beträgt beispielsweise 10% vom Messwert +- 5A Offset. Der Unterschied in den Messgenauigkeiten kann durch unterschiedliche Temperaturabhängigkeiten und/oder unterschiedliche Fertigungstoleranzen in einem Nennbetriebsbereich der beiden Sensorvorrichtungen bedingt sein. Unter Nennbetriebsbereich kann hier derjenige Messbereich verstanden werden, zu dem der erste Analog-Digital-Wandler unterschiedliche Digitalwerte liefert und/oder zu dem der im Folgenden erwähnte Digitalwertvergleicher einen Vergleich durchführt und/oder zu dem der im Folgenden erwähnte zweite Analog-Digital-Wandler unterschiedliche Digitalwerte liefert.

Die erste Sensorvorrichtung kann einen ersten Analog-Digital-Wandler zur Wandlung von analogen Messwerten in digitalisierte Messwerte umfassen. Durch die Digitalisierung schon am Ort der Messwertaufnahme kann eine Verfälschung der Messwerte durch deren Übertragung von der ersten Sensorvorrichtung zu einer Sensorsteuerung vermieden werden.

Die beiden Sensorvorrichtungen der Sensorbaugruppe und der erste Analog-Digital-Wandler können auf einem gemeinsamen Schaltungsträger angeordnet sein. Hierdurch hat auch die zweite Sensorbaugruppe den Vorteil, dass eine relative Lage der beiden Sensorvorrichtungen schon bei der Herstellung der Sensorbaugruppe auf demselben Schaltungsträger exakt positionier- und fixierbar sind, so dass aufwändige Justierarbeiten während des Einbaus der Sensorbaugruppe ins Zielgerät, beispielsweise beim Einbau in ein Fahrzeug, vermieden werden.

Der gemeinsame Schaltungsträger kann eine Platine mit einer gedruckten Schaltung, eine Dickfilm- und/oder eine Dünnfilmschaltung umfassen. Durch diese Maßnahmen können für die Sensorbaugruppe bewährte Aufbautechniken nutzbar gemacht werden.

Die erste Sensorvorrichtung kann einen Stromversorgungsschaltkreis aufweisen, der zu dem Stromversorgungsschaltkreis der zweiten Sensorvorrichtung elektrisch isoliert ist. Hierdurch wird eine Wahrscheinlichkeit verringert, dass eine Fehlfunktion einer der beiden Sensorvorrichtungen von der Sensorsteuerung nur deshalb nicht erkannt wird, weil sich die beiden Sensorvorrichtungen gegenseitig elektrisch beeinflussen. Sofern beispielsweise anhand von Plausibilitätsprüfungen erkannt werden kann, welcher der beiden Sensorvorrichtungen defekt ist, kann ein Notbetrieb mit nur einem der beiden Sensorvorrichtungen aufrechterhalten werden, wenn sich die beiden Sensorvorrichtungen nicht gegenseitig elektrisch beeinflussen.

Die erste Sensorvorrichtung kann einen Shunt und/oder Anschlüsse für einen Shunt umfassen und/oder die zweite Sensorvorrichtung kann einen Shunt und/oder Anschlüsse für einen Shunt umfassen. Mittels eines Shunts können insbesondere Ströme mit großer Stromstärke zuverlässig und kostengünstig gemessen werden, wobei als Messgröße ein Spannungsabfall genutzt wird, der an der Anschlussleitung der Stromquelle ohnehin auftritt.

Der erste Analog-Digital-Wandler kann Teil eines Mikrocontrollers der Sensorbaugruppe sein. Die Funktion eines Mikrocontrollers kann mittels Programmierung kostengünstig und zuverlässig laufend an neue Anforderungen und neue Erkenntnisse angepasst werden.

Die Sensorbaugruppe kann einen Anschluss zur Ausgabe der digitalen Darstellung der Messwerte umfassen, die von dem ersten Analog-Digital-Wandler erzeugt wird. Hierdurch kann eine Auswertung der von dem ersten Analog-Digital-Wandler erzeugten digitalen Ausgabewerte an einem Ort durchgeführt werden, an dem die Messwerte benötigt werden und an dem Raum- und Umgebungsbedingungen für eine Auswerteelektronik besser geeignet sind als am Ort der Messwertaufnahme.

Die zweite Sensorvorrichtung kann einen Stromsensor, der kein Shunt ist, insbesondere einen Stromsensor zur kontaktfreien Erfassung der Stärke des elektrischen Strom umfassen, wobei insbesondere bevorzugt der Stromsensor einen Magnetfeldsensor, ganz besonders bevorzugt einen Hallsensor oder einen anderen Sensor mit einem magnetoresistiven Effekt, umfassen. Mittels Anwendung physikalisch unterschiedlicher Stromstärkeerfassungstechniken können prinzip- oder systembedingte Fehler mit größerer Wahrscheinlichkeit als bei Anwendung übereinstimmender Stromstärkeerfassungskonzepte erkannt werden.

Die Sensorbaugruppe kann einen Anschluss für eine analoge Ausgabe der Messwerte umfassen, die von der zweiten Sensorvorrichtung erfassbar sind. Hierdurch kann die Digitalisierung und/oder der Vergleich der Messwerte der zweiten Sensorvorrichtung mit den Messwerten der ersten Sensorvorrichtung an einem Ort durchgeführt werden, an dem Raum- und Umgebungsbedingungen für eine Auswerteelektronik besser geeignet sind, als im Bereich der Sensorvorrichtungen. In diesem Fall braucht die Sensorbaugruppe keinen Analog-Digital-Wandler für die zweite Sensorvorrichtung aufweisen.

Erfindungsgemäß ist die bekannte Sensorsteuerung dadurch weitergebildet, dass sie einen Digitalwertvergleicher für einen digitalen Vergleich der Messwerte umfasst, die von den beiden Sensorvorrichtungen erfasst werden, wobei die Sensorsteuerung einen zweiten Analog-Digital-Wandler zur Wandlung der von der zweiten Sensorvorrichtung erfassten analogen Messwerte in digitalisierte Messwerte umfasst. Hierdurch ist es möglich, die von den beiden Sensorvorrichtungen erfassten Messwerte miteinander digital vergleichbar zu machen.

Alternativ oder zusätzlich kann die bekannte Sensorsteuerung dadurch weitergebildet sein, dass sie einen Analogwertvergleicher für einen analogen Vergleich der Messwerte umfasst, die von den beiden Sensorvorrichtungen erfasst werden, wobei die Sensorsteuerung einen Digital-Analog-Wandler zur Wandlung der von der ersten Sensorvorrichtung erfassten digitalisierten Messwerte in analoge Messwerte umfasst. Hierdurch ist es möglich, die von den beiden Sensorvorrichtungen erfassten Messwerte miteinander analog vergleichbar zu machen. Wenn der Vergleich der Messwerte, die von den beiden Sensorvorrichtungen erfasst werden, nur einer Fehlererkennung oder nur einer groben Plausibilitätsprüfung dient, braucht es kein Nachteil sein, wenn der Vergleich nur analog durchgeführt wird. Ein analoger Vergleich kann weniger elektrische Energie benötigen als ein digitaler Vergleich. Erfindungsgemäß ist die bekannte Strommessschaltung dadurch weitergebildet, dass die Strommessschaltung eine erfindungsgemäße Sensorbaugruppe und eine erfindungsgemäße Sensorsteuerung umfasst. Hierdurch werden Vorteile der erfindungsgemäßen Sensorbaugruppe und der erfindungsgemäßen Sensorsteuerung für die Strommessschaltung genutzt. Zur Übertragung analoger Messwerte der zweiten Sensorvorrichtung kann zwischen der zweiten Sensorvorrichtung und dem Analogwertvergleicher und/oder zwischen der zweiten Sensorvorrichtung und dem zweiten Analog-Digital-Wandler eine abgeschirmte Leitung angeordnet ist.

Die Erfindung wird nachfolgend anhand von Ausführungsbeispielen näher erläutert, die in den schematischen Zeichnungen dargestellt sind. Es zeigen:
- Fig. 1: ein schematisches Blockschaltbild einer Bordschaltung eines Kraftfahrzeugs;
- Fig. 2: ein schematisches Blockschaltbild einer ersten Ausführungsform einer Strommessschaltung;
- Fig. 3: ein schematisches Blockschaltbild einer zweiten Ausführungsform einer Strommessschaltung, wobei die Sensorsteuerung einen Digitalwertvergleicher umfasst;
- Fig. 4: ein schematisches Ablaufdiagramm für den Digitalwertvergleich der zweiten Ausführungsform;
- Fig. 5: ein schematisches Blockschaltbild einer dritten Ausführungsform der Strommessschaltung, wobei die Sensorsteuerung einen Analogwertvergleicher umfasst; und
- Fig. 6: ein schematisches Blockschaltbild eines Analogwertvergleichers für die dritte Ausführungsform.

In den Figuren werden für entsprechende Komponenten jeweils dieselben Bezugszeichen verwendet. Bezugszeichenbezogene Erläuterungen gelten daher figurenübergreifend, sofern sich aus dem Zusammenhang nichts anderes ergibt.

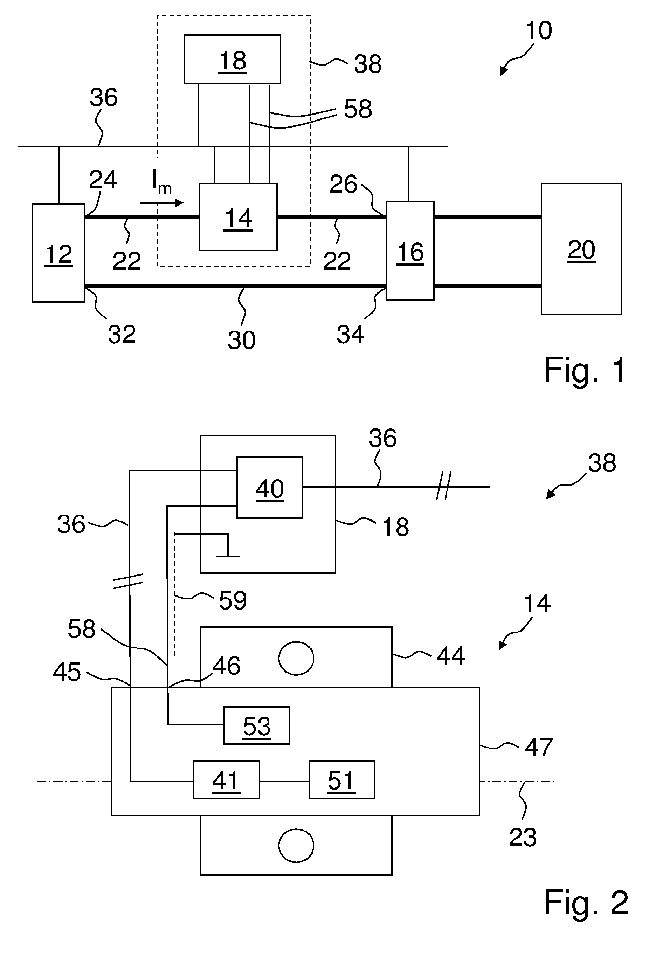

Die in Fig. 1 gezeigte Bordschaltung 10 eines Fahrzeugs, insbesondere Kraftfahrzeugs, umfasst eine Stromquelle 12 (beispielsweise eine Batterie, insbesondere eine wiederaufladbare Batterie und/oder eine Fahrzeugbatterie), eine Sensorbaugruppe 14, eine Stromversorgungstrennvorrichtung 16, eine Sensorsteuerung 18 und eine elektrische Last 20. Die elektrische Last 20 kann eine Vielzahl von Verbrauchern für elektrische Energie umfassen (beispielsweise Anlasser, Motorelektronik, Beleuchtung und Assistenzsysteme). Die Stromversorgungstrennvorrichtung 16 ist zweipolig in den Stromkreis zwischen Stromquelle 12 und der elektrischen Last 20 eingefügt. Die Sensorbaugruppe 14 ist in der Plusleitung 22 zwischen dem Plusanschluss 24 der Stromquelle 12 und dem Plusanschluss 26 der Stromversorgungstrennvorrichtung 16 angeordnet. Alternativ kann die Sensorbaugruppe 14 in der Minusleitung 30 zwischen dem Minusanschluss 32 der Stromquelle 12 und dem Minusanschluss 34 der Stromversorgungstrennvorrichtung 16 angeordnet sein. Die Sensorsteuerung 18 (beispielsweise in einem Stromversorgungssteuergerät oder in einem Batteriesteuergerät) ist mit der Stromquelle 12, der Sensorbaugruppe 14 und der Stromversorgungstrennvorrichtung 16 über einen Datenbus 36 (beispielsweise über einen CAN-Bus) verbunden. Die Sensorsteuerung 18 kann über den Datenbus 36 Messdaten von der Stromquelle 12 und der Sensorbaugruppe 14 empfangen. Die Sensorsteuerung 18 erhält über den Datenbus 36 beispielsweise aktuelle Temperaturmesswerte von der Stromquelle 12 und aktuelle Stromstärkemesswerte von der Sensorbaugruppe 14. In Abhängigkeit von diesen und/oder anderen Daten entscheidet die Sensorsteuerung 18, ob es der Stromversorgungstrennvorrichtung 16 über den Datenbus 36 befiehlt, den Stromkreis zwischen Stromquelle 12 und elektrischer Last 20 zu öffnen oder zu schließen.

Die in Fig. 2 gezeigte Strommessschaltung 38 der Bordschaltung 10 umfasst die Sensorsteuerung 18 und die Sensorbaugruppe 14. Die Sensorbaugruppe 14 umfasst eine Sensorplatine 47 und eine Befestigungskomponente 44. Auf der Sensorplatine 47 ist ein Hallsensor 53 und ein erster Analog-Digital-Wandler 41 für eine erste Sensorvorrichtung 51 angeordnet. Vorzugsweise sind die Stromkreise für die erste Sensorvorrichtung 51 und für den Hallsensor 53 auf der Sensorplatine 47 zueinander vollständig elektrisch getrennt, also elektrisch isoliert. Die Ausgabe der von der ersten Sensorvorrichtung 51 erfassten und digitalisierten Messwerte erfolgt über Anschluss 45. Die Ausgabe der von der zweiten Sensorvorrichtung 53 erfassten analogen Messwerte erfolgt über Anschluss 46. Die Befestigungskomponente 44 ermöglicht eine Anordnung der Sensorbaugruppe 14 im Bereich der Plusleitung 22 mit ausreichend genauer Positionierung für den Hallsensor 53 (bezogen auf eine Längsachse 23 der Plusleitung 22). Zur Auswertung der Messdaten und zur Steuerung der Stromversorgungstrennvorrichtung 16 ist in der Sensorsteuerung 18 ein Mikro-Controller 40 angeordnet. Im Ausführungsbeispiel der Fig. 2 wird die Analog-Digital-Wandlung des Messsignals des zweiten Sensors 53 sowie der Vergleich der Messwerte beider Sensorvorrichtungen 51, 53 innerhalb des Mikrocomputers 40 durchgeführt. In den Figuren 2, 3 und 5 ist an der Sensorsteuerung 18 je ein Anschluss an den Datenbus 36 für die Übermittlung der Messdaten aus der ersten Sensorvorrichtung 51 und für die Befehlsübermittlung zur Stromversorgungstrennvorrichtung 16 vorgesehen. Dies kann vorteilhaft sein, wenn die Eingabe bzw. Ausgabe über unterschiedliche Bussysteme erfolgen soll. Alternativ können der Anschluss für den Empfang der Messdaten aus der ersten Sensorvorrichtung 51 und der Anschluss für die Befehlsübermittlung zur Stromversorgungstrennvorrichtung 16 innerhalb der Sensorsteuerung 18 verbunden sein. Dann braucht aus der Sensorsteuerung 18 nur ein Anschluss für den Datenbus 36 herausgeführt sein.

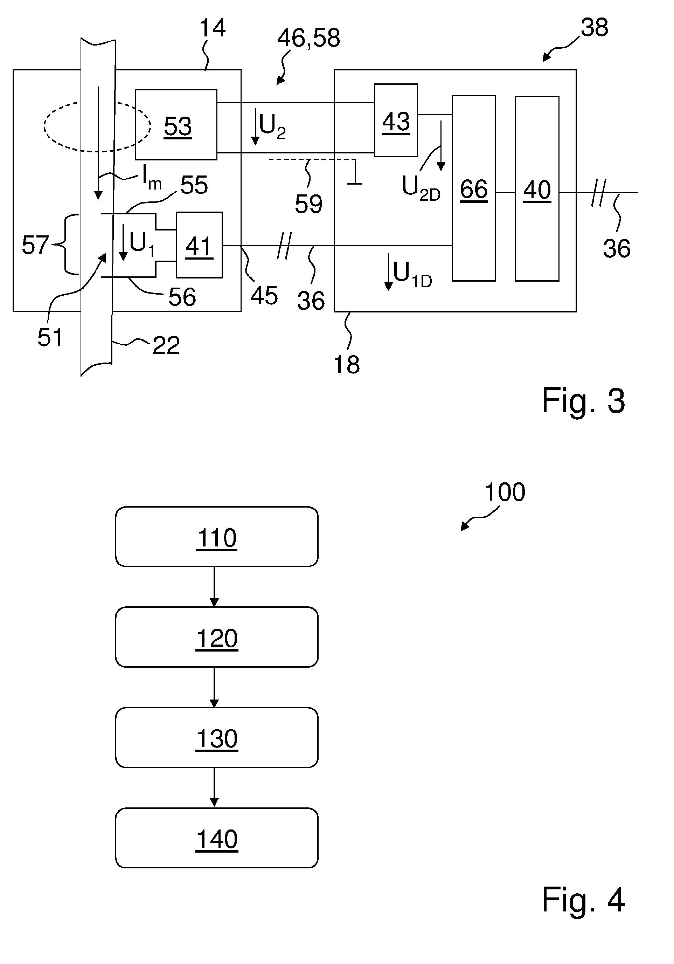

Wie in Fig. 3 schematisch dargestellt ist, kann als Shunt 50 ein Längsabschnitt 57 der Plusleitung 22 verwendet werden, wobei der Spannungsabfall U₁ an dem Shunt 50 mittels Kontakten 55, 56 an zwei unterschiedlichen Stellen der Plusleitung 22 abgegriffen und dem ersten Analog-Digital-Wandler 41 zugeführt wird. Insbesondere wenn die maximale Stromstärke auf der Plusleitung weniger als 1 A oder weniger als 100 mA beträgt, kann es zweckmäßig sein, den Shunt 50 auf der Sensorplatine 47 anzuordnen. Der erste Analog-Digital-Wandler 41 erzeugt aus dem Spannungsabfall U₁ an dem Shunt 50 ein Digitalsignal U_{1D}. Aus Übersichtsgründen sind in den Figuren die Spannungspfeile teilweise ohne Bezugspotential (also nur schematisch) eingezeichnet. Das Digitalsignal U_{1D} wird über eine Datenleitung, beispielsweise über einen Datenbus 36, zur Sensorsteuerung 18 übertragen und dort von dem Mikrocontroller 40 ausgewertet. Der Hallsensor 53 stellt an seinem Ausgang 46 eine Ausgangsspannung U₂ als Analogsignal bereit, wobei das Ausgangssignal den durch den Hallsensor 53 erfassten Messwert Iₘ repräsentiert. Die Ausgangsspannung U₂ wird von dem Hallsensor 53 vorzugsweise potentialfrei bereitgestellt. Diese Ausgangsspannung U₂ wird zwecks Auswertung mittels einer Analogleitung 58 zu dem Mikrocontroller 40 übertragen.

Zur Übertragung der analogen Messwerte der zweiten Sensorvorrichtung 53 mittels der Spannung U₂ kann zwischen der zweiten Sensorvorrichtung 53 und dem Analogwertvergleicher 80 und/oder zwischen der zweiten Sensorvorrichtung 53 und dem zweiten Analog-Digital-Wandler 43 eine Leitung 58 angeordnet sein, die abgeschirmt ist. Hierdurch ist eine Verfälschung des empfindlichen analogen Messsignals U₂ der zweiten Sensorvorrichtung 53 auf dem Weg von der Sensorbaugruppe 14 zu der Sensorsteuerung 18 vermeidbar. Es ist also von Vorteil, wenn die Analogleitung 58 eine Abschirmung 59 aufweist.

Im zweiten Ausführungsbeispiel wird (im Gegensatz zu dem Ausführungsbeispiel der Fig. 2) der Vergleich außerhalb des Mikrocomputers 40 durchgeführt. Die in Fig. 3 gezeigte zweite Ausführungsform der Strommessschaltung 38 erläutert eine erste Möglichkeit, den Messwert U₂ der zweiten Sensorvorrichtung 53 mit dem Messwert U₁ der ersten Sensorvorrichtung 51 zu vergleichen. Hierzu ist in der Strommessschaltung 38 ein zweiter Analog-Digital-Wandler 43 und ein Digitalwertvergleicher 66 angeordnet. Dem zweiten Analog-Digital-Wandler 43 wird das analoge Messsignal U₂ der zweiten Sensorvorrichtung 53 zugeführt. Dem Digitalwertvergleicher 66 wird das Digitalsignal U_{1D} aus dem ersten Analog-Digital-Wandler 41 und das Digitalsignal U_{2D} aus dem zweiten Analog-Digital-Wandler 43 zugeführt.

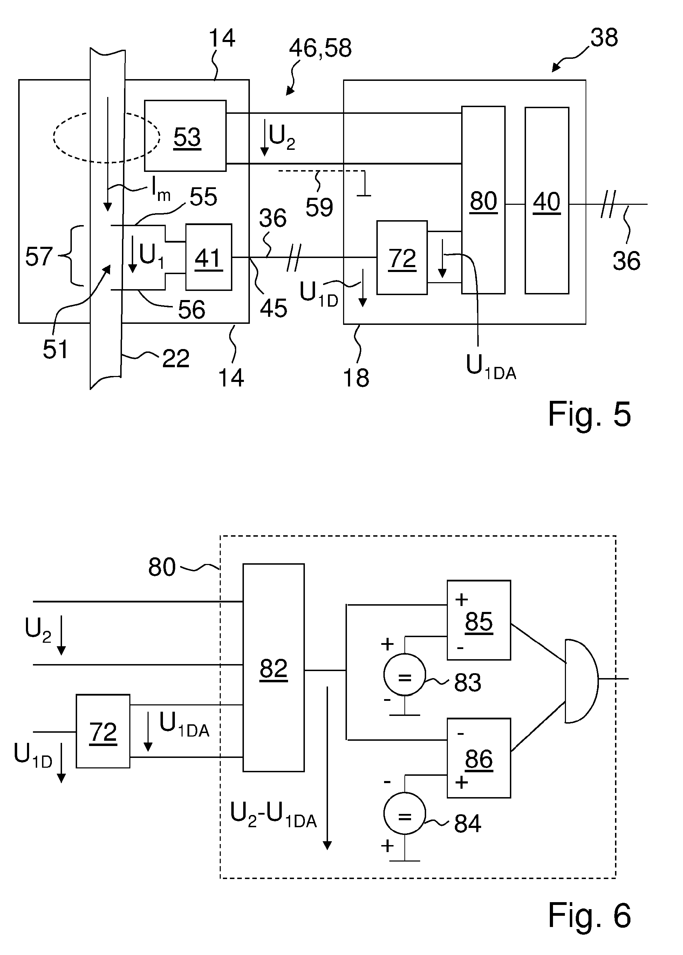

Das Ablaufdiagramm der Fig. 4 zeigt, mit welchen Schritten der Vergleich 100 im Digitalwertvergleicher 66 durchgeführt werden kann. Zur Durchführung dieser Berechnung 100 kann ein Mikrokontroller 40 oder ein ASIC vorgesehen sein. Der Digitalwertvergleich kann beispielsweise nach folgender Gleichung mittels einer Subtraktion 110, Betragsbildung 120 der beiden Digitalwerte U_{1D}, U_{2D}, Addition 130 mit einem Versatzwert -U_{REF} und Anwendung einer Heaviside Funktion H(x) 140 durchgeführt werden: Vergleichsergebnis = H (|U_{2D} - U_{1D}| + (-U_{REF})). Ein Digitalwertvergleicher 66 kann gegenüber einem Analogwertvergleicher 80 (siehe Fig. 5 und 6) aufgrund Programmierbarkeit den Vorteil eines geringeren Anpassungsaufwands an neue Anforderungen oder Erkenntnisse aufweisen.

Die in Fig. 5 gezeigte dritte Ausführungsform der Strommessschaltung 38 erläutert eine zweite Möglichkeit, den Messwert U₂ der zweiten Sensorvorrichtung 53 mit dem Messwert U₁ der ersten Sensorvorrichtung 51 zu vergleichen. Hierzu ist in der Strommessschaltung 38 ein Digital-Analog-Wandler 72 und ein Analogwertvergleicher 80 angeordnet. Dem Digital-Analog-Wandler 72 wird das digitalisierte Messsignal U_{1D} der ersten Sensorvorrichtung 51 zugeführt. Dem Analogwertvergleicher 80 wird das Analogsignal U_{1DA} aus dem Digital-Analog-Wandler 72 und das analoge Messsignal U₂ der zweiten Sensorvorrichtung 53 zugeführt. Die für das analoge Messsignal U₂ verwendete Analogleitung 58 weist vorzugsweise eine Abschirmung 59 auf.

Wie Fig. 6 zeigt, kann der Vergleich 100 im Analogwertvergleicher 80 beispielsweise mittels eines Operationsverstärkers 82 zum Subtrahieren, zwei Referenzspannungsquellen 83, 84 und zwei Schmitt-Triggern 85, 86 realisiert werden. Ein Analogwertvergleicher 80 kann gegenüber einem Digitalwertvergleicher 66 den Vorteil eines geringeren Stromverbrauchs aufweisen. Außerdem kann es von Vorteil sein, wenn statt eines zweiten Analog-Digitalwandlers 43 nur ein Digital-Analog-Wandler 72 benötigt wird. Wenn der Vergleich der Messwerte, die von den beiden Sensorvorrichtungen 51, 53 erfasst werden, nur einer Fehlererkennung oder nur einer groben Plausibilitätsprüfung dient, braucht es kein Nachteil sein, wenn der Vergleich der Messwerte nur analog durchgeführt wird.

Vorzugsweise umfasst die Strommessschaltung eine erfindungsgemäße Sensorbaugruppe und eine erfindungsgemäße Sensorsteuerung. Hierdurch werden Vorteile der erfindungsgemäßen Sensorbaugruppe und der erfindungsgemäßen Sensorsteuerung für gattungsgemäße Strommessschaltungen nutzbar.

Dieselben Schaltungsprinzipien können auch mit umgekehrter Polung angewendet werden. Analoge und/oder digitale elektrische Signale, die in den Ausführungsbeispielen in Gestalt von Spannungen dargestellt sind, können alternativ oder zusätzlich auch als (eingeprägte) Ströme dargestellt werden. Mittels Verstärkern oder Wandlern können in der Beschreibung erwähnte Spannungen oder Ströme auf dem Weg von ihrer jeweiligen Quelle zu ihrer jeweiligen Senke umskaliert werden. Analoge oder digitale Signale, die in Gestalt von Spannungen oder Strömen dargestellt sind, können nach einem bekannten oder nach einem heute noch nicht bekannten Verfahren linear oder nichtlinear codiert sein. Beispiele für anwendbare Codierungsverfahren sind Pulsweitenmodulation und Pulscodemodulation. Die analogen und/oder digitalen Signale können elektrisch, optisch oder per Funk übertragen werden. Die analogen und/oder digitalen Signale können im Raummultiplex (also mittels unterschiedlicher Leitungen), im Zeitmultiplex oder im Codemultiplex übertragen werden. Die Übertragung der analogen und digitalen Signale kann über ein oder mehrere Bussysteme erfolgen.

### Bezugszeichen:

- 10: Bordschaltung
- 12: Stromquelle; Fahrzeugbatterie
- 14: Sensorbaugruppe
- 16: Stromversorgungstrennvorrichtung
- 18: Sensorsteuerung
- 20: elektrische Last
- 22: Leiter; Plusleitung
- 23: Längsachse der Plusleitung
- 24: Plusanschluss der Stromquelle
- 26: Plusanschluss der Stromversorgungstrennvorrichtung
- 30: Minusleitung
- 32: Minusanschluss der Stromquelle
- 34: Minusanschluss der Stromversorgungstrennvorrichtung
- 36: Datenleitung; Datenbus; CAN-Bus
- 38: Strommessschaltung
- 40: Mikro-Controller
- 41: erster Analog-Digital-Wandler
- 43: zweiter Analog-Digital-Wandler
- 44: Befestigungskomponente
- 45: Anschluss für Ausgabe der von der ersten Sensorvorrichtung erfassten Messwerte
- 46: Anschluss für Ausgabe der von der zweiten Sensorvorr. erfassten Messwerte
- 47: Sensorplatine; Schaltungsträger
- 51: erste Sensorvorrichtung
- 53: zweite Sensorvorrichtung; Hallsensor; Magnetfeldsensor
- 57: Längsabschnitt der Plusleitung
- 55: erster Abgriff an der Plusleitung
- 58: Analogleitung
- 59: Abschirmung der Analogleitung 58
- 66: Digitalwertvergleicher
- 72: Digital-Analog-Wandler
- 80: Analogwertvergleicher
- 82: Operationsverstärkerschaltung zum Subtrahieren
- 83: erste Referenzspannungsquelle
- 84: zweite Referenzspannungsquelle
- 85: erster Schmitt-Trigger
- 86: zweiter Schmitt-Trigger
- 94: Testreferenzeingang
- 95: Teststromquelle
- 96: Steuerverbindung
- 100: Vergleich
- 110: Subtrahieren
- 120: Betragsbildung
- 130: Addition mit einem Versatzwert
- 140: Anwendung einer Heaviside-Funktion
- Im: zu messender Strom
- RS: Shunt
- U₁: analoger Messwert der ersten Sensorvorrichtung
- U_{1D}: digitalisierter Messwert der ersten Sensorvorrichtung
- U_{1DA}: rückgewandelter analoger Messwert der ersten Sensorvorrichtung
- U₂: analoger Messwert der zweiten Sensorvorrichtung
- U_{2D}: digitalisierter Messwert der zweiten Sensorvorrichtung

## Patentansprüche

1. Sensorbaugruppe (14) zur Messung einer Stärke eines durch einen Leiter (22) fließenden elektrischen Stroms (Iₘ), wobei die Sensorbaugruppe (14) eine erste Sensorvorrichtung (51) zur nicht kontaktfreien Erfassung der Stärke des elektrischen Stroms (Iₘ) und eine zweite Sensorvorrichtung (53) zur Erfassung der Stärke des elektrischen Stroms (Iₘ) umfasst, wobei beide Sensorvorrichtungen (51, 53) einen gemeinsamen Messbereich aufweisen, wobei die Sensorbaugruppe (14) einen ersten Analog-Digital-Wandler (41) zur Wandlung von analogen Messwerten (U₁) in digitalisierte Messwerte (U_{1D}) umfasst, **dadurch gekennzeichnet, dass** die beiden Sensorvorrichtungen (51, 53) und der erste Analog-Digital-Wandler (41) auf einem gemeinsamen Schaltungsträger (47) angeordnet sind.

2. Sensorbaugruppe (14) zur Messung einer Stärke eines durch einen Leiter (22) fließenden elektrischen Stroms (Iₘ), wobei die Sensorbaugruppe (14) eine erste Sensorvorrichtung (51) zur nicht kontaktfreien Erfassung der Stärke des elektrischen Stroms (Iₘ) und eine zweite Sensorvorrichtung (53) zur Erfassung der Stärke des elektrischen Stroms (Iₘ) umfasst, wobei beide Sensorvorrichtungen (51, 53) einen gemeinsamen Messbereich aufweisen, **dadurch gekennzeichnet, dass** eine Messgenauigkeit der zweiten Sensorvorrichtung (53) im gemeinsamen Messbereich schlechter als 0,5 %, insbesondere schlechter als 1 % oder 2%, insbesondere schlechter als 5%, ganz besonders bevorzugt schlechter als 10 %, ist.

3. Sensorbaugruppe (14) nach Anspruch 2, **dadurch gekennzeichnet, dass** die erste Sensorvorrichtung (51) einen ersten Analog-Digital-Wandler (41) zur Wandlung von analogen Messwerten (Iₘ) in digitalisierte Messwerte (U_{1D}) umfasst.

4. Sensorbaugruppe (14) nach Anspruch 3, **dadurch gekennzeichnet, dass** die beiden Sensorvorrichtungen (51, 53) der Sensorbaugruppe (14) und der erste Analog-Digital-Wandler (41) auf einem gemeinsamen Schaltungsträger (47) angeordnet sind.

5. Sensorbaugruppe (14) nach Anspruch 1 oder 4, **dadurch gekennzeichnet, dass** der gemeinsame Schaltungsträger (47) eine Platine mit einer gedruckten Schaltung, eine Dickfilm- und/oder eine Dünnfilmschaltung umfasst.

6. Sensorbaugruppe (14) nach einem der Ansprüche 1 bis 5, **dadurch gekennzeichnet, dass** die erste Sensorvorrichtung (51) einen Stromversorgungsschaltkreis aufweist, der zu dem Stromversorgungsschaltkreis der zweiten Sensorvorrichtung (53) elektrisch isoliert ist.

7. Sensorbaugruppe (14) nach einem der Ansprüche 1 bis 6, **dadurch gekennzeichnet, dass** die erste Sensorvorrichtung (51) einen Shunt (50) und/oder Anschlüsse (55, 56) für einen Shunt (50) umfasst und/oder dass die zweite Sensorvorrichtung (53) einen Shunt (50) und/oder Anschlüsse (55, 56) für einen Shunt (50) umfasst.

8. Sensorbaugruppe (14) nach einem der Ansprüche 1 bis 7, **dadurch gekennzeichnet, dass** der erste Analog-Digital-Wandler (41) Teil eines Mikrocontrollers der Sensorbaugruppe (14) ist.

9. Sensorbaugruppe (14) nach einem der Ansprüche 1 bis 8, **dadurch gekennzeichnet, dass** die Sensorbaugruppe (14) einen Anschluss (45) zur Ausgabe der digitalen Darstellung (U_{1D}) der Messwerte (U₁) umfasst, die von dem ersten Analog-Digital-Wandler (41) erzeugt wird.

10. Sensorbaugruppe (14) nach einem der Ansprüche 1 bis 9, **dadurch gekennzeichnet, dass** die zweite Sensorvorrichtung (53) einen Stromsensor, der kein Shunt ist, insbesondere einen Stromsensor zur kontaktfreien Erfassung der Stärke des elektrischen Stroms (Iₘ) umfasst, wobei insbesondere bevorzugt der Stromsensor einen Magnetfeldsensor, ganz besonders bevorzugt einen Hallsensor oder einen anderen Sensor mit einem magnetoresistiven Effekt, umfasst.

11. Sensorbaugruppe (14) nach einem der Ansprüche 1 bis 10, **dadurch gekennzeichnet, dass** die Sensorbaugruppe (14) einen Anschluss (46) für eine analoge Ausgabe der Messwerte (U₂) umfasst, die von der zweiten Sensorvorrichtung (53) erfassbar sind.

12. Sensorsteuerung (18) zur Steuerung einer Sensorbaugruppe (14) nach einem der Ansprüche 1 bis 11, **dadurch gekennzeichnet, dass** die Sensorsteuerung (18) einen Digitalwertvergleicher (66) für einen digitalen Vergleich der Messwerte (U₁, U₂) umfasst, die von den beiden Sensorvorrichtungen (51, 53) erfasst werden, wobei die Sensorsteuerung (18) einen zweiten Analog-Digital-Wandler (43) zur Wandlung der von der zweiten Sensorvorrichtung (53) erfassten analogen Messwerte (U₂) in digitalisierte Messwerte (U_{2D}) umfasst.

13. Sensorsteuerung (18) zur Steuerung einer Sensorbaugruppe (14) nach einem der Ansprüche 1 bis 11, **dadurch gekennzeichnet, dass** die Sensorsteuerung (18) einen Analogwertvergleicher (80) für einen analogen Vergleich der Messwerte (U₁, U₂) umfasst, die von den beiden Sensorvorrichtungen (51, 53) erfasst werden, wobei die Sensorsteuerung (18) einen Digital-Analog-Wandler (72) zur Wandlung der von der ersten Sensorvorrichtung (51) erfassten digitalisierten Messwerte (U_{1D}) in analoge Messwerte (U_{1DA}) umfasst.

14. Strommessschaltung (38) zur Messung der Stärke eines elektrischen Stroms (Iₘ), **dadurch gekennzeichnet, dass** die Strommessschaltung (38) eine Sensorbaugruppe (14) nach einem der Ansprüche 1 bis 11 und eine Sensorsteuerung (18) nach einem der Ansprüche 12 oder 13 umfasst.

15. Strommessschaltung (38) nach Anspruch 14, **dadurch gekennzeichnet, dass** zur Übertragung analoger Messwerte (U₂) der zweiten Sensorvorrichtung (52) zwischen der zweiten Sensorvorrichtung (52) und dem Analogwertvergleicher (80) und/oder zwischen der zweiten Sensorvorrichtung (52) und dem zweiten Analog-Digital-Wandler (42) eine abgeschirmte Leitung (58) angeordnet ist.
